# DEMANDE DE BREVET EUROPEEN

(11) **EP 3 809 473 A1**
(43) Date de publication de la demande: **21.04.2021**
(21) Numéro de dépôt: 20201582.2
(22) Date de dépôt: 13.10.2020
(51) Int. Cl.: H01L 31/18, H01L 31/05

(54) **PROCÉDÉ D'INTERCONNEXION DE CELLULES PHOTOVOLTAÏQUES AVEC DES FILS MÉTALLIQUES AU CONTACT DE PLOTS DE PÂTE À BRASER**

(30) Priorité: 16.10.2019 FR 1911532
(71) Demandeur: Commissariat à l'énergie atomique et aux énergies alternatives, 75015 Paris (FR)
(72) Inventeur: COMMAULT, Benjamin, 38054 GRENOBLE Cedex 09 (FR); BETTINELLI, Armand, 38054 GRENOBLE Cedex 09 (FR); LEFILLASTRE, Paul, 38054 GRENOBLE Cedex 09 (FR)
(74) Mandataire: Brevalex

(57) **Abrégé**

L'objet principal de l'invention est un procédé d'interconnexion de cellules photovoltaïques (4), recouvertes d'une grille de métallisation (11) comprenant des doigts de collecte pour l'interconnexion avec des fils métalliques (6b), le procédé comportant : l'étape de dépôt d'une pluralité de plots de pâte à braser (20) espacés les uns des autres sur les doigts de collecte sur au moins une partie des emplacements destinés à former les intersections entre les fils métalliques (6b) et les doigts de collecte ; l'étape de dépôt des fils métalliques (6b) sur les plots de pâte à braser (20), mise en œuvre par un dispositif de distribution des fils (21) configuré pour tendre et presser les fils métalliques (6b) sur les cellules photovoltaïques, et permettant leur positionnement en vis-à-vis des plots de pâte à braser (20), sur ladite au moins une partie des emplacements.

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en œuvre pour de nombreuses applications, notamment pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades, en particulier pour une intégration sur des voitures, bus ou bateaux, entre autres.

L'invention propose ainsi un procédé d'interconnexion de cellules photovoltaïques utilisant des fils métalliques au contact de plots de pâte à braser, ainsi qu'un procédé de fabrication d'un module photovoltaïque associé.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur typiquement comprise entre 2 et 4 mm, classiquement de l'ordre de 3 mm.

La deuxième couche formant la face arrière du module photovoltaïque peut quant à elle être réalisée à base de verre ou de métal, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm.

Les cellules photovoltaïques, se présentant sous forme de fines plaques d'environ 180 µm d'épaisseur, peuvent être reliées électriquement entre elles (interconnectées) par des éléments de contact électrique avant et arrière, appelés conducteurs de liaison, et formés par exemple par des bandes (ou rubans) ou fils de cuivre étamé, notamment respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

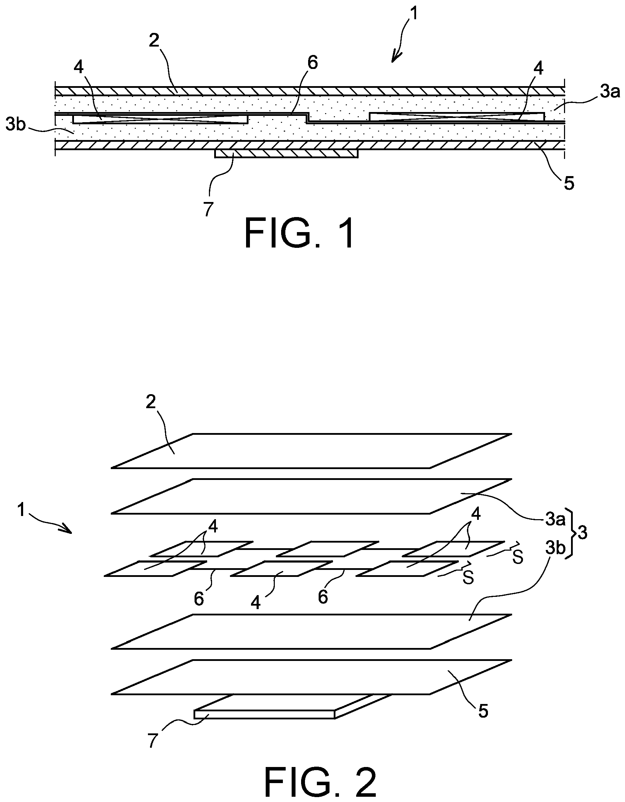

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

Par ailleurs, les figures 1 et 2 représentent également la boîte de jonction 7 du module photovoltaïque 1, destinée à recevoir le câblage nécessaire à l'exploitation du module et raccordant les bandes de cuivre du circuit de cellules photovoltaïques. Classiquement, cette boîte de jonction 7 est réalisée en plastique ou en caoutchouc, et présente une étanchéité complète. Enfin, bien que non représenté sur les figures 1 et 2, un cadre en aluminium est prévu autour de l'ensemble des couches décrites auparavant pour finaliser le module photovoltaïque.

Ainsi, un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées, ou « pseudo-carrées », de 156 mm de côté, réparties en six chaînes ou séries S, comme visible sur la figure 2, appelées encore « strings » selon la dénomination anglaise, de dix cellules interconnectées en série. Les six chaînes de cellules photovoltaïques sont également interconnectées en série.

Les porteurs de charge photogénérés, qui contribuent au courant électrique de la cellule photovoltaïque, sont collectés grâce à un réseau d'électrodes déposé sur la face avant de la cellule. Ces électrodes, appelées également doigts de collecte, sont étroites, typiquement de dimension inférieure à 100 µm. Elles sont généralement formées par sérigraphie d'une pâte contenant de l'argent. La face arrière de la cellule est soit recouverte d'un autre réseau d'électrodes (cas des cellules bifaciales), soit d'une couche métallique pleine, par exemple en aluminium (cas des cellules monofaciales). Le courant électrique circule ensuite d'une cellule à l'autre de la chaîne par des interconnexions.

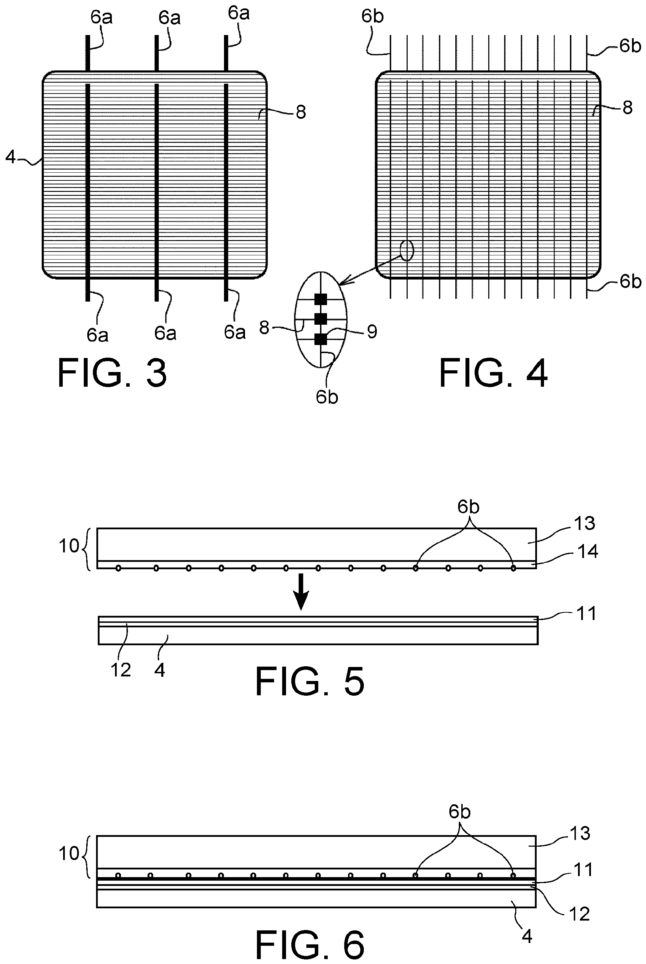

La présente invention est ainsi concernée par l'interconnexion des cellules photovoltaïques. On distingue classiquement deux techniques majeures pour interconnecter les cellules photovoltaïques d'une chaîne : les interconnexions en forme de ruban et les interconnexions en forme de fil métallique. Il s'agit habituellement de fils ou de rubans de cuivre recouverts d'un revêtement fusible, par exemple à base d'étain ou d'indium. Ces deux techniques sont respectivement représentées par les figures 3 et 4.

Sur la figure 3, les interconnexions entre les cellules 4 sont constituées de rubans 6a en cuivre recouverts d'un alliage fusible, typiquement un alliage d'étain et de plomb ou un alliage d'étain et d'argent. Ces rubans 6a de section rectangulaire sont soudés sur des pistes conductrices appelées « busbars » et formées en même temps que les doigts de collecte 8 par sérigraphie. Les busbars relient électriquement les doigts de collecte 8 et sont orientés perpendiculairement aux doigts de collecte 8.

Une cellule de 156 mm x 156 mm compte généralement trois rubans de 1,5 mm de large ou quatre rubans de 1,2 mm de large, ces rubans ayant une épaisseur de l'ordre de 0,2 mm. Chaque ruban 6a connecte la face avant d'une cellule 4 à la face arrière de la cellule 4 suivante dans la chaîne (non représentée sur la figure 3). La mise en série des cellules photovoltaïques 4 au moyen des rubans 6a s'effectue de façon entièrement automatisée, dans un équipement appelé « stringer ».

Plusieurs équipementiers proposent dorénavant de remplacer les rubans de cuivre par des fils métalliques de plus faible section. Par exemple, la technologie « Multi-Busbar» développée par la société « Schmid » et décrite dans l'article « Multi-busbar solar cells and modules : high efficiencies and low silver consumption », S. Braun et al., Energy Procedia, vol. 38, pp. 334-339, 2013, multiplie le nombre de busbars déposés sur la cellule, passant de trois à quinze busbars, et soude à chaque busbar un fil de 200 µm de diamètre. Cette technologie est schématisée sur la figure 4. Les fils 6b sont constitués de cuivre et recouverts d'une fine couche d'un alliage à base d'étain-plomb ou d'étain-argent dont le point de fusion est situé au-dessus de 170°C. Les busbars ont une forme discontinue. Ils se composent de plots de métallisation 9, d'environ 500 µm x 700 µm, alignés sur les doigts de collecte 8. Les plots de métallisation 9 et les doigts de collecte 8 sont généralement réalisés par sérigraphie d'une pâte d'argent. La soudure des fils 6b sur les plots 9 a lieu immédiatement après avoir posé les fils 6b sur les plots 9, dans le même équipement, en chauffant ces éléments à une température de l'ordre de 200°C. Ainsi, l'alliage recouvrant les fils 6b de cuivre est fondu.

Par ailleurs, la technologie « SmartWire » développée par la société « Meyer Burger », connue de DE 102 39 845 C1 et également décrite dans l'article « Smart Wire Connection Technology», T. Söderström et al., Proceedings of the 28th European Photovoltaics Solar Energy Conference, pp. 495-499, 2013, consiste à déposer une nappe de 18 à 36 fils de 200 µm ou 300 µm de diamètre directement sur les doigts de collecte. Autrement dit, les cellules photovoltaïques sont dépourvues de busbars. Les fils sont tenus par un film support en cellophane, acétate ou fluororésine, par exemple, qui est collé sur chaque face des cellules. Les fils ont une âme en cuivre et un revêtement extérieur formé d'un alliage à faible point de fusion. Cet alliage possède une température de fusion inférieure à 150°C, ce qui permet de réaliser la connexion électrique entre les fils et les doigts de collecte, non pas lors de l'étape d'interconnexion des cellules (par chauffage localisé vers 100°C), mais lors de l'étape de lamination des modules photovoltaïques (qui se fait à plus haute température, généralement vers 150-160°C).

Les figures 5 et 6 permettent d'illustrer le principe de la technologie « SmartWire ». La figure 5 illustre schématiquement, en coupe, l'application du film support 10 sur la sérigraphie 11 de la cellule photovoltaïque 4, et la figure 6 illustre schématiquement, en coupe, l'interconnexion électrique obtenue de la cellule 4 de la figure 5 après application du film support 10.

Ainsi, les fils 6b sont tenus par le film support 10 qui comprend une couche 13 en cellophane, acétate ou fluororésine, par exemple, et une couche adhésive 14 de type acrylique, élastomère (ou caoutchouc), polyvinyle éther, ou encore époxy, sur laquelle sont placés les fils 6b. Comme visible sur la figure 5, ce film support 10 est alors plaqué sur la sérigraphie 11 de la cellule 4, cette sérigraphie 11 comprenant les doigts de collecte 8, pour obtenir la structure de la figure 6. De plus, sur ces figures 5 et 6, on peut également voir qu'une couche anti-reflet 12 est prévue entre la cellule photovoltaïque 4 et la sérigraphie 11. Cette couche anti-reflet 12 est typiquement une couche d'oxyde d'indium-étain (ou encore ITO pour « Indium Tin Oxide » en anglais) ou encore une couche de nitrure de silicium (SiN).

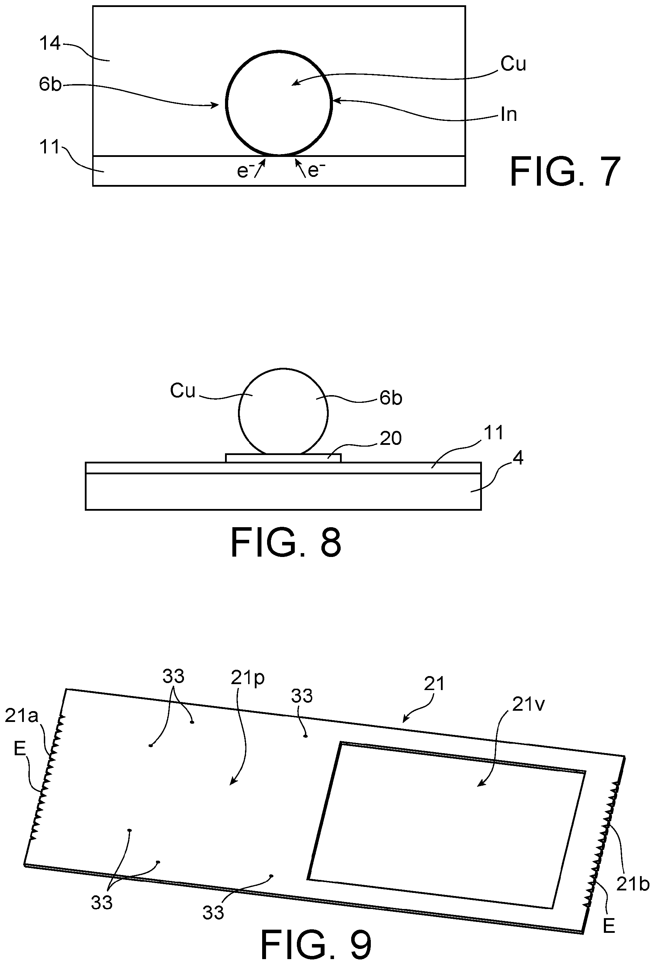

En outre, la figure 7 illustre schématiquement et partiellement, en coupe, le contact électrique obtenu entre un fil 6b et la sérigraphie 11 pour la structure de la figure 6. Plus précisément, le fil 6b comporte une âme en cuivre Cu et un revêtement extérieur formé d'un alliage à faible point de fusion. Au contact avec les doigts de collecte de la sérigraphie 11 a lieu le passage des électrons e⁻.

Les interconnexions en forme de fil métallique permettent de réduire la longueur des doigts de collecte par rapport à la configuration à trois busbars (voir la figure 3), car le nombre de fils est plus important que le nombre de rubans. Cette augmentation du nombre d'interconnexions n'a pas nécessairement d'impact sur l'ombrage de la cellule photovoltaïque en raison de la plus petite taille des fils. Par contre, elle permet de réduire considérablement la quantité d'argent utilisée pour imprimer les doigts de collecte. En effet, les doigts de collecte étant moins longs, on peut soit réduire la largeur des doigts, soit utiliser une pâte moins riche en argent, et donc moins conductrice, pour une résistance série équivalente. En outre, grâce à leur section circulaire, les fils métalliques ont un ombrage effectif sur la cellule photovoltaïque inférieur à celui des rubans plats. Ainsi, pour un ensemble d'interconnexions ayant une même section transversales, le taux d'ombrage sur des cellules interconnectées par fils est plus faible que celui sur des cellules interconnectées par rubans.

L'utilisation d'un revêtement fusible continu sur les fils ou rubans de cuivre dans les technologies d'interconnexions en forme de ruban, d'interconnexions en forme de fil et « SmartWire » présente plusieurs inconvénients, parmi lesquels une quantité de matière excessive pour le revêtement fusible et une certaine fragilité dans la connexion obtenue entre les doigts de collecte et les fils ou rubans. Il existe ainsi un besoin pour proposer une solution alternative d'interconnexion.

### EXPOSÉ DE L'INVENTION

L'invention a pour but de remédier au moins partiellement aux besoins mentionnés précédemment et aux inconvénients relatifs aux réalisations de l'art antérieur.

L'invention a ainsi pour objet, selon l'un de ses aspects, un procédé d'interconnexion de cellules photovoltaïques, les cellules photovoltaïques étant recouvertes d'une grille de métallisation, notamment réalisée par sérigraphie, comprenant des doigts de collecte pour l'interconnexion avec des fils métalliques, le procédé comportant :
- l'étape de dépôt d'une pluralité de plots de pâte à braser espacés les uns des autres sur les doigts de collecte sur au moins une partie des emplacements, notamment sur la totalité des emplacements, voire encore sur une partie seulement des emplacements, destinés à former les intersections entre les fils métalliques et les doigts de collecte,
- l'étape de dépôt des fils métalliques sur les plots de pâte à braser, mise en œuvre à l'aide d'un dispositif de distribution des fils configuré pour tendre les fils métalliques et presser les fils métalliques sur les cellules photovoltaïques, le dispositif de distribution des fils permettant en outre le positionnement des fils métalliques en vis-à-vis des plots de pâte à braser, sur ladite au moins une partie des emplacements destinés à former les intersections entre les fils métalliques et les doigts de collecte.

Le procédé d'interconnexion selon l'invention peut permettre d'éviter le recours à un revêtement en un alliage fusible sur les fils métalliques, ce qui représente une économie de matière car la quantité de matière des plots de pâte à braser est faible en comparaison avec un revêtement continu des fils métalliques comme selon les solutions de l'art antérieur. De plus, la connexion réalisée entre les doigts de collecte et les fils métalliques peut être plus robuste car les zones d'interconnexion peuvent être plus larges à chaque emplacement destiné à former une intersection entre fils métalliques et doigts de collecte. Le volume de soudure apporté par les plots de pâte à braser peut en effet être supérieur à celui de fils revêtus de façon homogène d'un alliage fusible.

Le procédé d'interconnexion selon l'invention permet également une précision suffisante de positionnement des fils sur toute la longueur à interconnnecter. Cela permet un procédé avec des plots suffisamment petits de façon à limiter au maximum leur ombrage de la cellule.

Le procédé d'interconnexion selon l'invention peut en outre comporter l'une ou plusieurs des caractéristiques suivantes prises isolément ou suivant toutes combinaisons techniques possibles.

Les plots de pâte à braser peuvent comporter un alliage fusible, par exemple à base d'étain ou d'indium.

Avantageusement, l'étape de dépôt de la pluralité de plots de pâte à braser peut être réalisée par sérigraphie.

Les plots de pâte à braser peuvent présenter une longueur comprise entre 400 µm et 2mm, une largeur comprise entre 50 µm et 200 µm et une épaisseur comprise entre 30 µm et 120 µm.

De façon privilégiée, les fils métalliques peuvent être des fils constitués d'un unique métal ou alliage métallique, notamment de cuivre. En variante, les fils métalliques peuvent être des fils constitués d'une âme en métal ou alliage métallique, notamment en cuivre, et d'un revêtement organique ou inorganique de protection contre l'oxydation.

Par ailleurs, les fils métalliques peuvent présenter un diamètre compris entre 100 µm et 400 µm. Leur nombre peut être compris entre 5 et 50, de préférence entre 10 et 40.

Avantageusement, l'étape de dépôt de la pluralité de plots de pâte à braser peut être réalisée sur les deux faces des cellules photovoltaïques.

En outre, le procédé peut comporter, après l'étape de dépôt d'une pluralité de plots de pâte à braser sur les doigts de collecte et avant l'étape de dépôt des fils métalliques sur les plots de pâte à braser, une étape de fusion de la pâte à braser des plots de pâte à braser, notamment par le biais d'un flux d'air chaud, par passage dans un four de refusion et/ou par chauffage infrarouge.

Les fils métalliques peuvent être dépourvus de tout revêtement en un alliage fusible.

Après l'étape de dépôt des fils métalliques sur les plots de pâte à braser, le procédé peut comporter une étape de fusion ou de refusion de la pâte à braser des plots de pâte à braser, notamment par le biais d'un flux d'air chaud, par passage dans un four de refusion et/ou par un chauffage infrarouge.

Cette étape permet ensuite de réaliser des caractérisations des cellules, notamment la mesure de leur caractéristique IV sous éclairement après l'étape de dépôt des plots.

Par ailleurs, les fils métalliques peuvent être solidarisés, en particulier une fois positionnés, aux cellules photovoltaïques par le biais d'un film support, comportant notamment un matériau polymère, formant ainsi une électrode.

Lors de l'utilisation d'un film support, les cellules photovoltaïques peuvent être recouvertes d'une couche anti-reflet, notamment une couche d'oxyde d'indium-étain (ITO) ou encore une couche de nitrure de silicium (SiN), en vis-à-vis du film support. En outre, le film support peut comporter une couche polymère, notamment une couche en cellophane, acétate ou fluororésine, et une couche adhésive, notamment une couche de type acrylique, élastomère, polyvinyle éther ou époxy, la couche adhésive comportant la pluralité de fils métalliques.

Par ailleurs, le dispositif de distribution des fils peut comporter des rouleaux rainurés pour le positionnement et la mise sous tension des fils métalliques.

Préférentiellement, le dispositif de distribution des fils peut se présenter sous la forme d'un cadre comprenant, sur deux bords opposés, des encoches pour le positionnement et la mise sous tension des fils métalliques, ainsi qu'une partie pleine et une partie ajourée adjacentes situées entre les deux bords opposés.

L'étape de dépôt des fils métalliques sur les plots de pâte à braser peut alors comporter :
- le positionnement d'une première cellule photovoltaïque sur la partie pleine du cadre, notamment contre des éléments de blocage, par exemple des goupilles,
- la mise en place et le maintien des fils métalliques dans les encoches, le maintien étant notamment réalisé par le biais de pinces de maintien,
- la fusion de la pâte à braser des plots de pâte à braser, notamment par le biais d'un flux d'air chaud, par passage dans un four de refusion et/ou par chauffage infrarouge, et/ou l'ajout d'un film support, notamment en polymère, pour la solidarisation des fils métalliques sur les cellules photovoltaïques,
- la découpe des fils métalliques de part et d'autre de la première cellule photovoltaïque et le retrait de la première cellule photovoltaïque.

Par ailleurs, le procédé peut en plus comporter :
- le positionnement d'une deuxième cellule photovoltaïque sur la partie pleine du cadre, notamment contre des éléments de blocage, par exemple des goupilles,
- la mise en place et le maintien des fils métalliques dans les encoches, le maintien étant notamment réalisé par le biais de pinces de maintien,
- la fusion de la pâte à braser des plots de pâte à braser, notamment par le biais d'un flux d'air chaud, par passage dans un four de refusion et/ou par chauffage infrarouge, et/ou l'ajout d'un film support, notamment en polymère, pour la solidarisation des fils métalliques sur les cellules photovoltaïques,
- le positionnement de la première cellule photovoltaïque sur les fils métalliques situés en regard de la partie ajourée du cadre, la face de la première cellule photovoltaïque comprenant déjà une interconnexion de fils métalliques étant opposée à la partie ajourée du cadre,
- la fusion de la pâte à braser des plots de pâte à braser, notamment par le biais d'un flux d'air chaud, par passage dans un four de refusion et/ou par chauffage infrarouge, pour l'interconnexion des fils métalliques sur la face de la première cellule photovoltaïque située en vis-à-vis de la partie ajourée du cadre, et/ou l'ajout d'un film support, notamment en polymère, pour la solidarisation des fils métalliques sur les cellules photovoltaïques,
- la découpe des fils métalliques de part et d'autre des première et deuxième cellules photovoltaïques et le retrait de la série formée par les première et deuxième cellules photovoltaïques.

En outre, l'invention a encore pour objet, selon un autre de ses aspects, un procédé de fabrication d'un module photovoltaïque comportant :
- une première couche transparente formant la face avant du module photovoltaïque, destinée à recevoir un flux lumineux,
- une pluralité de cellules photovoltaïques disposées côte à côte et reliées électriquement entre elles par le procédé d'interconnexion de cellules photovoltaïques tel que défini précédemment,
- un ensemble encapsulant la pluralité de cellules photovoltaïques,
- une deuxième couche formant la face arrière du module photovoltaïque, l'ensemble encapsulant et la pluralité de cellules photovoltaïques étant situés entre les première et deuxième couches.

Le terme « transparent » signifie que le matériau de la première couche formant la face avant du module photovoltaïque est au moins partiellement transparent à la lumière visible, laissant passer au moins environ 80 % de cette lumière.

En outre, par le terme « encapsulant », il faut comprendre que la pluralité de cellules photovoltaïques est disposée dans un volume, par exemple hermétiquement clos vis-à-vis des liquides, au moins en partie formé par au moins une couche composée d'un matériau polymère dit d'encapsulation. En général, on utilise au moins deux couches d'encapsulation disposées de part et d'autre des cellules photovoltaïques et réunies entre elles après assemblage, notamment par lamination, pour former l'ensemble encapsulant les cellules. Ainsi, initialement, c'est-à-dire avant toute opération d'assemblage, l'ensemble encapsulant peut être constitué par au moins deux couches de matériau d'encapsulation, dites couches de cœur, entre lesquelles la pluralité de cellules photovoltaïques est encapsulée. Toutefois, pendant l'opération d'assemblage, le ou les matériaux d'encapsulation fondent pour ne former, après l'opération d'assemblage, qu'une seule couche (ou ensemble) solidifiée dans laquelle sont noyées ou encapsulées les cellules photovoltaïques.

L'ensemble encapsulant peut notamment être réalisé à partir d'au moins un matériau polymère choisi parmi : le poly(éthylène-acétate de vinyle) (EVA), les ionomères, les polyoléfines, les acétals de vinyle, tels que les polyvinylbutyrals (PVB), les chlorures de polyvinyle (PVC), les polydiméthylsiloxanes, les polyuréthanes (PU) ou encore le polyméthacrylate de méthyle (PMMA), l'éthylène-acrylate de méthyle (EMA), le butylacrylate d'éthylène (EBA), l'éthylène-propylène (EPM/EPDM).

Par ailleurs, le procédé de fabrication selon l'invention peut comporter l'étape de lamination à chaud, à une température supérieure ou égale à 90°C, notamment supérieure ou égale à 100°C, notamment encore supérieure ou égale à 120°C, et pendant une durée du cycle de lamination d'au moins 10 minutes, des couches constitutives du module photovoltaïque.

La première couche peut être réalisée en verre, ou encore en au moins un matériau polymère, tel que le polyméthacrylate de méthyle (PMMA), le polycarbonate (PC), des fibres de verre ou de carbone imprégnées, entre autres. La deuxième couche peut être réalisée en verre, en métal ou encore en au moins un matériau polymère tel que le polyméthacrylate de méthyle (PMMA), le polycarbonate (PC), des fibres de verre ou de carbone imprégnées, entre autres.

De plus, l'ensemble encapsulant peut préférentiellement être réalisé à partir de deux couches de poly(éthylène-acétate de vinyle) (EVA) entre lesquelles sont disposées les cellules photovoltaïques.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres. Par ailleurs, les cellules photovoltaïques peuvent présenter une épaisseur comprise entre 1 et 300 µm.

Le module photovoltaïque peut en outre comporter une boîte de jonction, destinée à recevoir le câblage nécessaire à l'exploitation du module photovoltaïque.

Par ailleurs, quand bien même la première couche formant la face avant du module photovoltaïque est transparente, la deuxième couche formant la face arrière du module photovoltaïque peut être ou non transparente, étant notamment opaque.

Le procédé d'interconnexion et le procédé de fabrication selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
La figure 1 représente, en coupe, un exemple classique de module photovoltaïque comportant des cellules photovoltaïques cristallines,
La figure 2 représente, en vue éclatée, le module photovoltaïque de [Fig. 1],
La figure 3 et la figure 4 représentent schématiquement deux techniques d'interconnexion de cellules photovoltaïques selon l'art antérieur,
La figure 5 illustre schématiquement, en coupe, l'application d'une électrode sur la sérigraphie d'une cellule photovoltaïque selon le principe d'interconnexion « SmartWire »,
La figure 6 illustre schématiquement, en coupe, l'interconnexion électrique obtenue de la cellule photovoltaïque de la figure 5 après application de l'électrode,
La Figure 7 illustre schématiquement et partiellement, en coupe, le contact électrique obtenu entre un fil métallique et la sérigraphie pour la cellule photovoltaïque de la figure 6,
La figure 8 illustre schématiquement, selon une vue en coupe, un des principes de l'invention visant à l'interconnexion de cellules photovoltaïques par le biais de fils métalliques et de plots de pâte à braser,
La figure 9 illustre, en perspective, un exemple de dispositif de distribution des fils sous la forme d'un cadre,
Les Figures 10A, 10B, 10C, 10D, 10E, 10F et 10G illustrent schématiquement des étapes de l'interconnexion conforme à l'invention entre une première et une deuxième cellules photovoltaïques,
Les Figures 11A, 11B, 11C, 11D, 11E, 11F et 11G, 11H et Fig. 11I illustrent schématiquement des étapes de l'interconnexion conforme à l'invention entre une troisième cellule photovoltaïque et les première et deuxième cellules photovoltaïques, et
Les figures 12A et 12B illustrent schématiquement des étapes de l'interconnexion conforme à l'invention entre une quatrième cellule photovoltaïque et les première, deuxième et troisième cellules photovoltaïques.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1 à 7 ont déjà été décrites dans la partie relative à l'état de la technique antérieure et au contexte technique de l'invention.

Les éléments communs aux figures 1 à 7 et aux figures 8 à 12B ne sont donc pas décrits de nouveau. Toutefois, l'enseignement décrit en référence aux figures 1 à 7 est applicable aux exemples selon l'invention décrits en lien avec les figures 8 à 12B, en particulier concernant l'utilisation d'un film support 10 pour l'interconnexion et la formation des doigts de collecte 8 par sérigraphie 11.

De plus, il est à noter qu'un module photovoltaïque 1 obtenu par le procédé de fabrication conforme à l'invention peut comporter des couches constitutives semblables à celles décrites en référence aux figures 1 et 2, lesquelles ne sont donc pas décrites de nouveau.

La figure 8 illustre très schématiquement, selon une vue en coupe, un des principes de l'invention visant à l'interconnexion de cellules photovoltaïques 4 par le biais de fils métalliques 6b nus, c'est-à-dire dépourvus de tout revêtement en alliage fusible comme selon les solutions de l'art antérieur décrites précédemment.

Les cellules photovoltaïques 4 sont recouvertes d'une grille de métallisation sous la forme d'une couche de sérigraphie 11 qui comprend des doigts de collecte 8 décrits précédemment. Les fils métalliques 6b utilisés sont par exemple en cuivre et uniquement constitués de cuivre Cu. En variante, les fils métalliques 6b peuvent être des fils constitués d'une âme en cuivre et d'un revêtement organique ou inorganique, par exemple 1 µm d'étain, de protection contre l'oxydation, mais ils sont dépourvus de tout revêtement en alliage fusible permettant leur interconnexion avec les doigts de collecte 8 puisque celle-ci est réalisée par le biais des plots de pâte à braser 20.

L'interconnexion des cellules photovoltaïques 4 se fait donc par le biais de l'interconnexion des fils métalliques 6b avec la sérigraphie 11 à l'aide de plots de pâte à braser 20. Ces plots de pâte à braser 20 sont disposés de façon espacés les uns des autres sur la sérigraphie 11 et situés aux emplacements destinés à former les intersections entre les fils métalliques 6b et les doigts de collecte 8.

Aussi, le procédé d'interconnexion selon l'invention met en œuvre l'étape de dépôt des plots de pâte à braser 20 sur la sérigraphie 11, et l'étape de dépôt des fils métalliques 6b sur les plots de pâte à braser 20.

L'étape de dépôt des plots de pâte à braser 20 est avantageusement réalisée par sérigraphie, autrement dit par le même procédé que celui permettant la formation des doigts de collecte 8.

De plus, les fils métalliques 6b utilisés peuvent être au nombre de 5 à 50 fils, et préférentiellement de 10 à 40 fils. Leur diamètre peut être compris entre 100 µm et 400 µm.

Par ailleurs, l'étape de dépôt des plots de pâte à braser 20 est réalisée sur les deux faces des cellules photovoltaïques 4.

Les plots de pâte à braser 20 présentent avantageusement une longueur comprise entre 400 µm et 2mm, une largeur comprise entre 50 µm et 200 µm et une épaisseur comprise entre 30 µm et 120 µm. De préférence, les plots 20 sont de dimensions longueur x largeur x épaisseur égales à 800 µm x 100 µm x 60 µm.

Selon un premier exemple de mise en œuvre de l'invention, reposant sur la deuxième technique d'interconnexion avec fils métalliques décrites précédemment, le procédé d'interconnexion comporte une étape de dépôt des plots de pâte à braser 20 sur les deux faces des cellules photovoltaïques 4.

De manière optionnelle, après cette étape de dépôt des plots de pâte à braser 20 sur les doigts de collecte 8 et avant l'étape de dépôt des fils métalliques 6b sur les plots de pâte à braser 20, une étape de première fusion de la pâte à braser des plots 20 peut être réalisée, par exemple par le biais d'un flux d'air chaud, par passage dans un four de refusion et/ou par chauffage infrarouge. Après le refroidissement rapide, les cellules photovoltaïques 4 peuvent donc être manipulées de façon classique. Cela facilite donc le dépôt des plots de pâte à braser 20 sur les deuxièmes faces des cellules 4 puisqu'il n'y a pas de précautions à prendre, par exemple des rainurages dans la table de sérigraphie, pour éviter d'abîmer les dépôts de pâte fraîche situés sur les premières faces. Il est donc possible d'utiliser les équipements classiques du domaine du photovoltaïque.

Cette étape de première fusion optionnelle permet de dissocier la partie impression de la pâte à braser du « stringer ». L'étape de dépôt de la pâte à braser sur la deuxième face peut dans ce cas être réalisée en fin du procédé d'obtention des cellules et après les dépôts et refusion des plots de pâte à braser 20 de la première face des cellules. On peut par exemple réaliser des caractérisations des cellules, notamment la mesure de leur caractéristique IV sous éclairement et mettre les cellules photovoltaïques 4 en boîte comme c'est classiquement le cas en sortie des équipements de tri des cellules appelés « sorters » en anglais.

Par la suite, l'étape de dépôt des fils métalliques 6b est mise en œuvre. Les fils métalliques 6b sont tendus et pressés sur les cellules photovoltaïques 4. Cette étape peut être mise en œuvre à l'aide d'un dispositif de distribution des fils 21, tel que représenté en perspective sur la figure 9. Ce dispositif de distribution des fils 21 est configuré pour tendre les fils métalliques 6b et presser les fils métalliques 6b sur les cellules photovoltaïques 4. Ce dispositif de distribution des fils 21 permet en outre le positionnement des fils métalliques 6b en vis-à-vis des plots de pâte à braser 20, aux emplacements destinés à former les intersections entre les fils métalliques 6b et les doigts de collecte 8.

Comme visible sur la figure 9, le dispositif de distribution des fils 21 peut se présenter sous la forme d'un cadre 21 comprenant, sur deux bords opposés 21a et 21b, des encoches E pour le positionnement et la mise sous tension des fils métalliques 6b, ainsi qu'une partie pleine 21p et une partie ajourée 21v adjacentes situées entre les deux bords opposés 21a, 21b.

En variante, le dispositif de distribution des fils 21 pourrait comporter des rouleaux rainurés pour le positionnement et la mise sous tension des fils métalliques 6b. L'utilisation de tels rouleaux peut permettre d'éviter tout risque de cisaillement des fils 6b lors de leur guidage et mise sous tension.

Le dimensionnement des plots de pâte à braser 20, notamment leur longueur, peut être adapté à la précision de localisation des fils 6b.

Alors, après cette étape de dépôt des fils métalliques 6b sur les plots de pâte à braser 20 à l'aide du dispositif de distribution des fils 21, une étape de fusion ou de refusion (si une première fusion a été réalisée) de la pâte à braser des plots de pâte à braser 20 est réalisée lorsque les fils 6b sont en contact avec les plots 20. Cette fusion peut par exemple se faire par le biais d'un flux d'air chaud (préférentiel), par passage dans un four de refusion et/ou par un chauffage infrarouge. Cette étape permet ainsi de former les séries ou « strings » de cellules 4 comme pour un procédé classique de soudure de rubans.

A l'issue de cette étape, les cellules photovoltaïques 4 sont interconnectées entre elles, et le module photovoltaïque 1 peut être fabriqué comme selon l'enseignement issu des figures 1 et 2.

De manière avantageuse, ce premier exemple de mise en œuvre de l'invention permet d'éviter le recours à un revêtement fusible sur les fils métalliques 6b, permettant ainsi une économie de matière car la quantité de matière fusible pour réaliser les plots 20 est, par sa localisation, bien plus faible que la quantité d'alliage utilisée pour un revêtement classique continu sur toute la périphérie et la longueur des fils métalliques. Il n'y a pas non plus d'utilisation de film support pour les fils 6b, donc la puissance délivrée par le module est supérieure du fait d'un courant accru en l'absence d'absorption de la lumière par le film support. Il n'y a pas non plus de problème de vieillissement du film support.

Selon un deuxième exemples de mise en œuvre de l'invention, reposant sur la troisième technique d'interconnexion de type « SmartWire » décrite précédemment, avec utilisation d'un film support 10, le procédé d'interconnexion comporte une étape de dépôt des plots de pâte à braser 20 sur les deux faces des cellules photovoltaïques 4.

Tout comme précédemment, et de manière optionnelle, après cette étape de dépôt des plots de pâte à braser 20 sur les doigts de collecte 8 et avant l'étape de dépôt des fils métalliques 6b sur les plots de pâte à braser 20, une étape de première fusion de la pâte à braser des plots 20 peut être réalisée, par exemple par le biais d'un flux d'air chaud, par passage dans un four de refusion et/ou par chauffage infrarouge. On retrouve ainsi les avantages décrits précédemment pour le premier exemple de mise en œuvre de l'invention.

Par la suite, l'étape de dépôt des fils métalliques 6b est mise en œuvre. Cette étape peut être réalisée de la manière suivante.

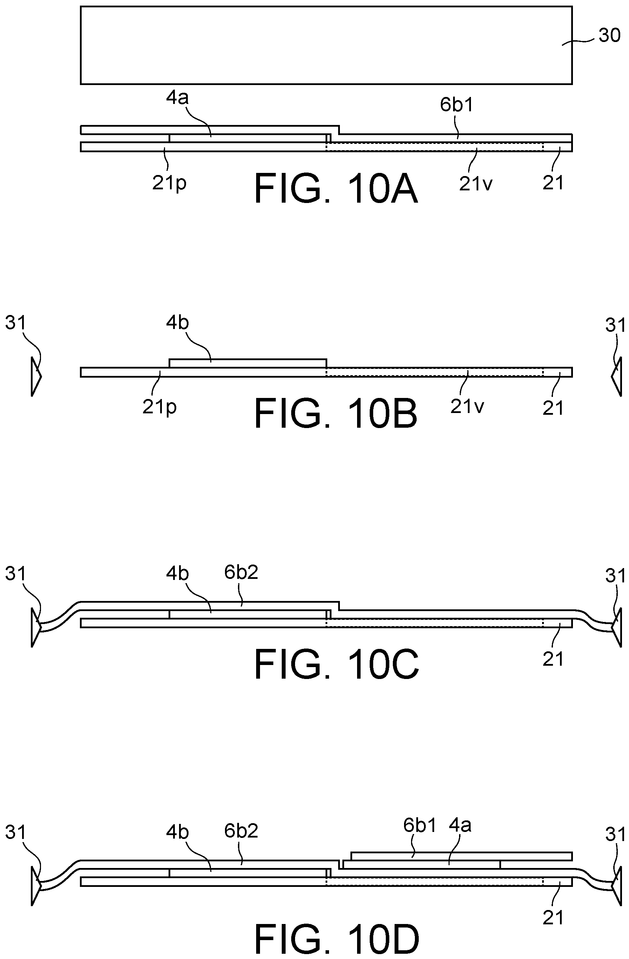

Cette manière va être décrite à l'aide des figures 10A à 12B. Elle repose sur l'utilisation d'un dispositif de distribution des fils 21 tel que celui représenté sur la figure 9 et décrit précédemment.

La figure 10A illustre, en coupe partielle, le dépôt des fils 6b1 sur une première cellule photovoltaïque 4a. Sur cette figure 10A, les traits en pointillés illustrent la partie ajourée 21v du cadre 21. La première cellule photovoltaïque 4a est placée sur la partie pleine 21p du cadre 21, contre des éléments de blocage du cadre 21, par exemple des goupilles 33. Ensuite, les fils métalliques 6b1 sont mis en place et maintenus dans les encoches E du cadre 21. Chaque fil 6b1 est maintenu à chaque extrémité par une pince 31 (visible sur la figure 10B). Les fils 6b1 sont tendus parallèlement les uns autres. Les pinces 31 peuvent être placées légèrement plus bas que le niveau du cadre 21, préférentiellement de 1 mm à 10 mm en dessous, de façon à placer les fils dans les encoches E et obtenir un positionnement précis des fils 6b1.

Les fils 6b1 sont préférentiellement tendus à chaud, par exemple à une température supérieur à 100°C, ou maintenus sous tension constante par les pinces 31 pour éviter de se détendre lors de leur soudure.

Les fils 6b1 sont pressés sur la face avant de la première cellule photovoltaïque 4a et alors la fusion de la pâte à braser des plots de pâte à braser 20 est réalisée. Cette fusion est préférentiellement réalisée par le biais d'un flux d'air chaud d'un dispositif de chauffage 30, ou encore par passage dans un four de refusion et/ou par chauffage infrarouge.

Par la suite, un écartement d'un côté de l'extrémité de l'ensemble des fils 6b1 est réalisé à l'aide des pinces 31 et une découpe des fils métalliques 6b1 de part et d'autre de la première cellule photovoltaïque 4a est réalisée, en étant proche du bord de la cellule 4a, par exemple de 2 à 3 mm à l'intérieur de la cellule 4a, à l'aide de ciseaux ou de pinces coupantes. Un écartement et une découpe similaires sont réalisés de l'autre côté. Enfin, la première cellule 4a est retirée.

Le procédé se poursuit alors avec la deuxième cellule photovoltaïque 4b dont les modalités d'interconnexion vont être décrites à l'aide des figures 10B à 10G illustrant de manière partielle différentes étapes d'interconnexion de la deuxième cellule photovoltaïque 4b avec la première cellule photovoltaïque 4a.

Ainsi, en référence à la figure 10b, une deuxième cellule photovoltaïque 4b est placée dans la partie pleine 21p du cadre 21, positionnée contre les goupilles 33.

Puis, comme l'illustre la figure 10C, des fils métalliques 6b2 sont mis en place et maintenus par les encoches E du cadre 21 et les pinces 31. Les fils 6b2 sont tendus parallèlement les uns aux autres et un film support 10 (non représenté) est collé aux fils, préférentiellement à l'aide d'un flux d'air chaud ou d'une plaque chauffante. L'utilisation du cadre 21 permet d'obtenir un bon alignement des fils 6b2 et des plots de pâte à braser 20.

Par la suite, les fils 6b2 sont pressés sur la face avant de la deuxième cellule 4b et la fusion de la pâte à braser des plots de pâte à braser 20 est réalisée.

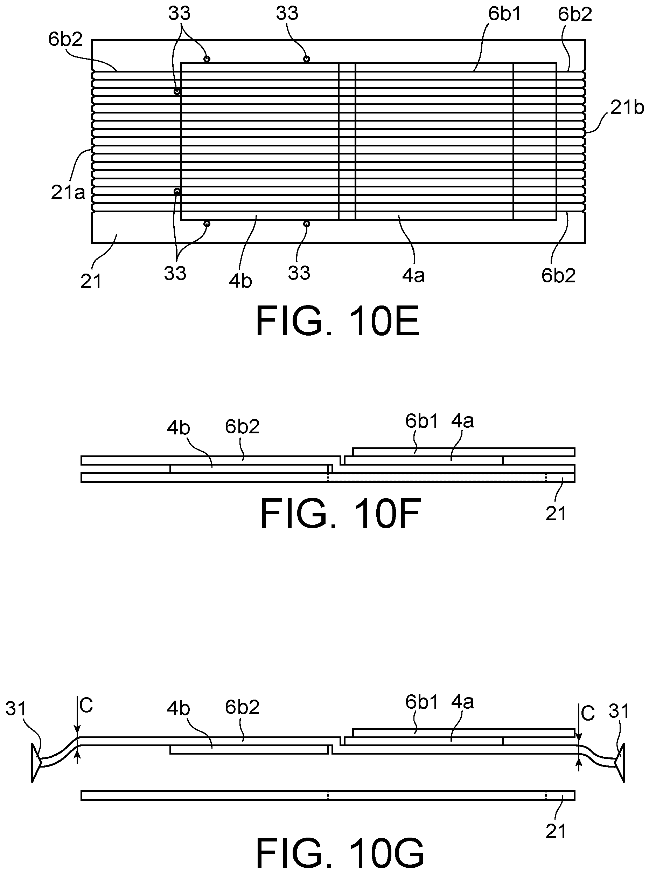

La figure 10D, en coupe, et la figure 10E, en perspective, et la figure 10F, qui est la vue en coupe de la figure 10E, permettent d'illustrer l'étape suivante d'interconnexion des première 4a et deuxième 4b cellules photovoltaïques.

Ainsi, on positionne la première cellule photovoltaïque 4a, dont la face avant a précédemment été interconnectée, sur les fils métalliques tendus 6b2 situés en regard de la partie ajourée 21v du cadre 21, la face avant de la première cellule photovoltaïque (4a) comprenant déjà une interconnexion de fils métalliques 6b1 étant opposée à la partie ajourée 21v du cadre 21. L'alignement de la métallisation de la face arrière de la première cellule 4a est alors vérifié et corrigé si besoin grâce à la partie ajourée 21v du cadre 21.

On réalise ensuite la fusion de la pâte à braser des plots de pâte à braser 20, par exemple par le biais d'un flux d'air chaud, par passage dans un four de refusion et/ou par chauffage infrarouge, pour l'interconnexion des fils métalliques 6b2 sur la face de la première cellule photovoltaïque 4a située en vis-à-vis de la partie ajourée 21v du cadre 21. Autrement dit, on réalise l'interconnexion des fils 6b2 à la face arrière de la première cellule photovoltaïque 4a.

Comme l'illustre alors la figure 10G, on soulève ensuite l'ensemble des fils 6b2 à l'aides pinces 31 et on coupe les fils métalliques 6b2 de part et d'autre des première 4a et deuxième 4b cellules photovoltaïques légèrement à l'intérieur, par exemple de quelques millimètres, par exemple à l'aide de ciseaux ou de pinces coupantes. Les flèches C sur la figure 10G illustrent les lieux de découpe. On soulève ensuite les cellules 4a, 4b à l'aide de ventouses par exemple, puis on baisse l'ensemble des fils du côté de la première cellule 4a à l'aide des pinces 31 et on coupe les fils.

Ensuite, comme précédemment, un écartement, une découpe des fils et un retrait des cellules 4a, 4b formant une série S sont effectués.

Il est alors possible de poursuivre l'interconnexion des cellules photovoltaïques selon le même principe jusqu'à ce que la série S soit terminée.

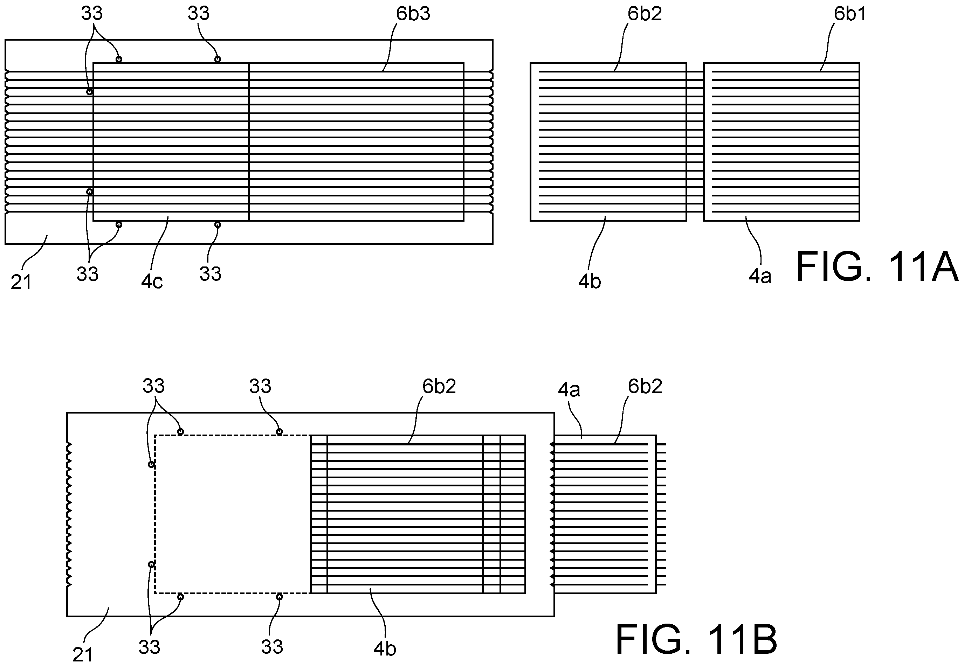

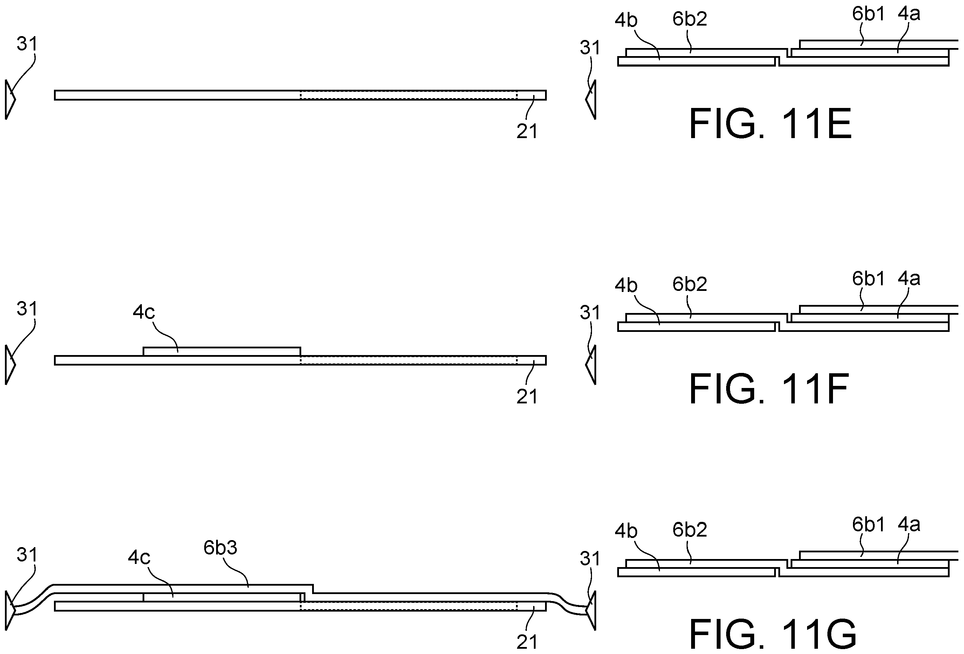

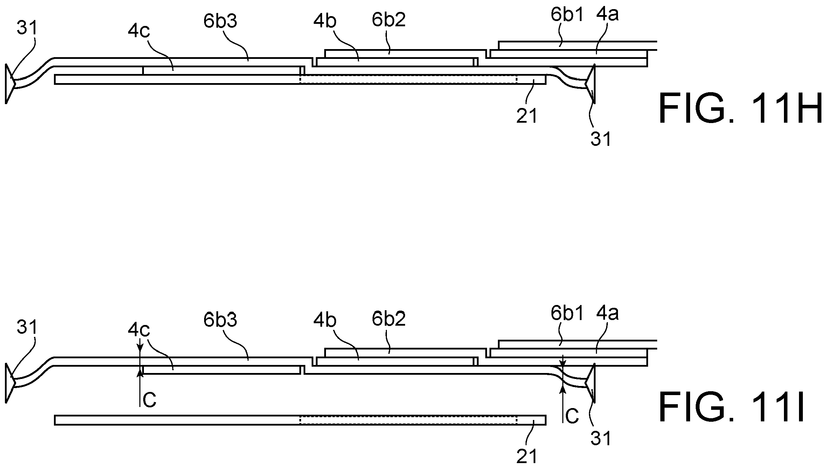

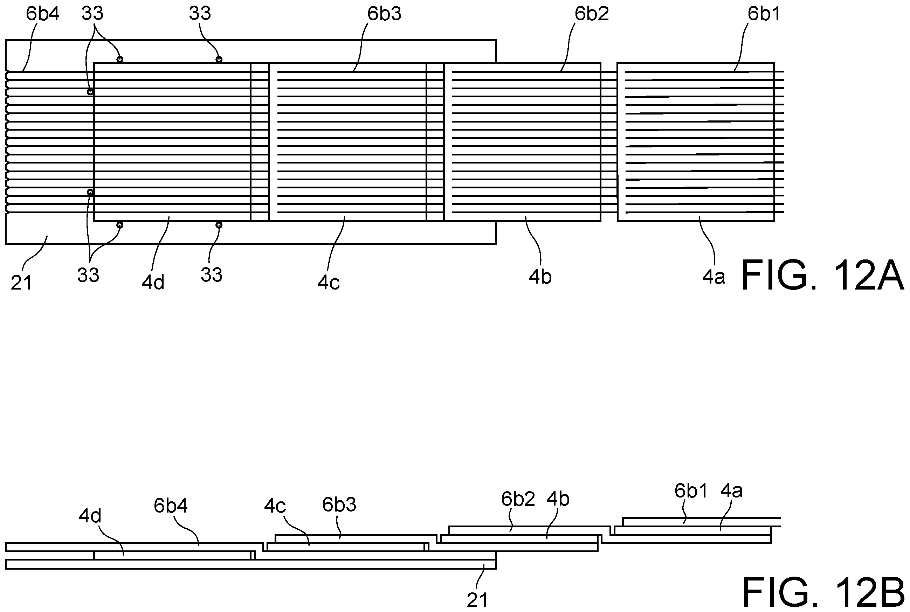

Ainsi, les figures 11A à 11I illustrent différentes étapes pour l'interconnexion d'une troisième cellule photovoltaïque 4c aux première 4a et deuxième 4b cellules photovoltaïques. De même, les figures 12A et 12B illustrent des étapes pour l'interconnexion d'une quatrième cellule photovoltaïque 4d aux première 4a, deuxième 4b et troisième 4c cellules photovoltaïques.

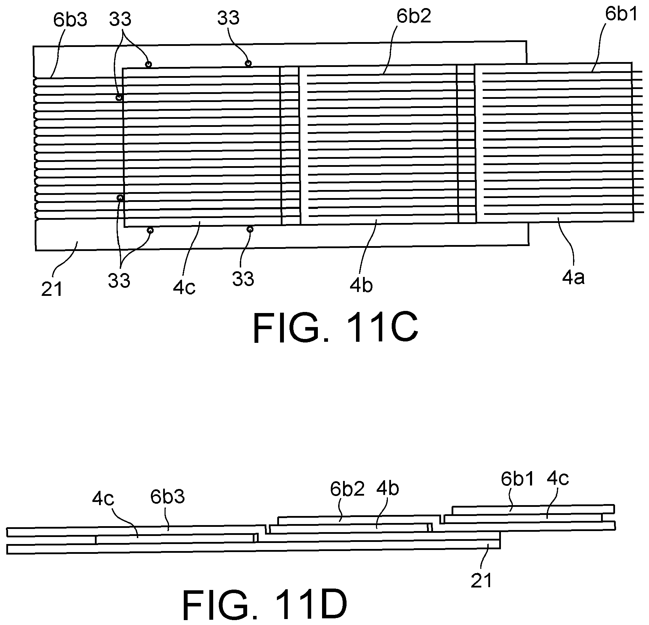

La figure 11A est une vue analogue à celle de la figure 10E, les première 4a et deuxième 4b cellules n'étant pas encore positionnées sur le cadre 21. La figure 11B représente la vue arrière de la configuration de la figure 11A avec les première 4a et deuxième 4b cellules positionnées sur le cadre 21. La figure 11C représente la vue avant de la configuration de la figure 11A avec les première 4a et deuxième 4b cellules positionnées sur le cadre 21. La figure 11D est une vue en coupe de la figure 11C.

Les figures 11D à 11I sont des vues en coupe illustrant le procédé d'interconnexion entre les trois cellules 4a, 4b, 4c de façon analogue à la séquence décrite en lien avec les figures 10B à 10G.

Les figures 12A et 12B sont des vues analogues à celles des figures 11C et 11D dans le cas de l'interconnexion avec les quatre cellules photovoltaïques 4a, 4b, 4c et 4d.

En conséquence, il convient de se référer à la description de l'interconnexion des première 4a et deuxième 4b cellules photovoltaïques décrite précédemment pour la compréhension de l'interconnexion des troisième 4c et quatrième 4d cellules photovoltaïques avec les première 4a et deuxième 4b cellules photovoltaïques, utilisant les fils métalliques 6b1, 6b2, 6b3 et 6b4.

A l'issue de cette interconnexion des cellules photovoltaïques, le module photovoltaïque 1 peut être fabriqué comme selon l'enseignement issu des figures 1 et 2.

Bien entendu, l'invention n'est pas limitée aux exemples de réalisation qui viennent d'être décrits. Diverses modifications peuvent y être apportées par l'homme du métier.

## Revendications

1. Procédé d'interconnexion de cellules photovoltaïques (4, 4a, 4b, 4c, 4d), les cellules photovoltaïques (4, 4a, 4b, 4c, 4d) étant recouvertes d'une grille de métallisation (11) comprenant des doigts de collecte (8) pour l'interconnexion avec des fils métalliques (6b, 6b1, 6b2, 6b3), le procédé comportant :
- l'étape de dépôt d'une pluralité de plots de pâte à braser (20) espacés les uns des autres sur les doigts de collecte (8) sur au moins une partie des emplacements destinés à former les intersections entre les fils métalliques (6b, 6b1, 6b2, 6b3) et les doigts de collecte (8),
- l'étape de dépôt des fils métalliques (6b, 6b1, 6b2, 6b3) sur les plots de pâte à braser (20), mise en œuvre à l'aide d'un dispositif de distribution des fils (21) configuré pour tendre les fils métalliques (6b, 6b1, 6b2, 6b3) et presser les fils métalliques (6b, 6b1, 6b2, 6b3) sur les cellules photovoltaïques (4, 4a, 4b, 4c, 4d), le dispositif de distribution des fils (21) permettant en outre le positionnement des fils métalliques (6b, 6b1, 6b2, 6b3) en vis-à-vis des plots de pâte à braser (20), sur ladite au moins une partie des emplacements destinés à former les intersections entre les fils métalliques (6b, 6b1, 6b2, 6b3) et les doigts de collecte (8).

2. Procédé selon la revendication 1, **caractérisé en ce que** l'étape de dépôt de la pluralité de plots de pâte à braser (20) est réalisée par sérigraphie.

3. Procédé selon la revendication 1 ou 2, **caractérisé en ce que** les plots de pâte à braser (20) présentent une longueur comprise entre 400 µm et 2mm, une largeur comprise entre 50 µm et 200 µm et une épaisseur comprise entre 30 µm et 120 µm.

4. Procédé selon l'une des revendications précédentes, **caractérisé en ce que** les fils métalliques (6b, 6b1, 6b2, 6b3) sont des fils constitués d'un unique métal ou alliage métallique, notamment de cuivre.

5. Procédé selon l'une des revendications 1 à 3, **caractérisé en ce que** les fils métalliques (6b, 6b1, 6b2, 6b3) sont des fils constitués d'une âme en métal ou alliage métallique, notamment en cuivre, et d'un revêtement organique ou inorganique de protection contre l'oxydation.

6. Procédé selon l'une quelconque des revendications précédentes, **caractérisé en ce que** l'étape de dépôt de la pluralité de plots de pâte à braser (20) est réalisée sur les deux faces des cellules photovoltaïques (4, 4a, 4b, 4c, 4d).

7. Procédé selon l'une quelconque des revendications précédentes, **caractérisé en ce qu'**il comporte, après l'étape de dépôt d'une pluralité de plots de pâte à braser (20) sur les doigts de collecte (8) et avant l'étape de dépôt des fils métalliques (6b, 6b1, 6b2, 6b3) sur les plots de pâte à braser (20), une étape de fusion de la pâte à braser des plots de pâte à braser (20), notamment par le biais d'un flux d'air chaud, par passage dans un four de refusion et/ou par chauffage infrarouge.

8. Procédé selon l'une quelconque des revendications précédentes, **caractérisé en ce que**, après l'étape de dépôt des fils métalliques (6b, 6b1, 6b2, 6b3) sur les plots de pâte à braser (20), le procédé comporte une étape de fusion ou de refusion de la pâte à braser des plots de pâte à braser (20), notamment par le biais d'un flux d'air chaud, par passage dans un four de refusion et/ou par un chauffage infrarouge.

9. Procédé selon l'une quelconque des revendications précédentes, **caractérisé en ce que** les fils métalliques (6b, 6b1, 6b2, 6b3) sont dépourvus de tout revêtement en un alliage fusible.

10. Procédé selon l'une quelconque des revendications précédentes, caractérisé en ce les fils métalliques (6b, 6b1, 6b2, 6b3) sont solidarisés aux cellules photovoltaïques (4, 4a, 4b, 4c, 4d) par le biais d'un film support (10), comportant notamment un matériau polymère.

11. Procédé selon l'une quelconque des revendications précédentes, **caractérisé en ce que** le dispositif de distribution des fils (21) se présente sous la forme d'un cadre (21) comprenant, sur deux bords opposés (21a, 21b), des encoches (E) pour le positionnement et la mise sous tension des fils métalliques (6b, 6b1, 6b2, 6b3), ainsi qu'une partie pleine (21p) et une partie ajourée (21v) adjacentes situées entre les deux bords opposés (21a, 21b).

12. Procédé selon la revendication 11, **caractérisé en ce que** l'étape de dépôt des fils métalliques (6b, 6b1, 6b2, 6b3) sur les plots de pâte à braser (20) comporte :
- le positionnement d'une première cellule photovoltaïque (4a) sur la partie pleine (21p) du cadre (21), notamment contre des éléments de blocage (33), par exemple des goupilles,
- la mise en place et le maintien des fils métalliques (6b1) dans les encoches (E), le maintien étant notamment réalisé par le biais de pinces de maintien (31),
- la fusion de la pâte à braser des plots de pâte à braser (20), notamment par le biais d'un flux d'air chaud, par passage dans un four de refusion et/ou par chauffage infrarouge, et/ou l'ajout d'un film support (10), notamment en polymère, pour la solidarisation des fils métalliques sur les cellules photovoltaïques (4, 4a, 4b, 4c, 4d),
- la découpe des fils métalliques (6b1) de part et d'autre de la première cellule photovoltaïque (4a) et le retrait de la première cellule photovoltaïque (4a).

13. Procédé selon la revendication 12, **caractérisé en ce qu'**il comporte en outre :
- le positionnement d'une deuxième cellule photovoltaïque (4b) sur la partie pleine (21p) du cadre (21), notamment contre des éléments de blocage (33), par exemple des goupilles,
- la mise en place et le maintien des fils métalliques (6b2) dans les encoches (E), le maintien étant notamment réalisé par le biais de pinces de maintien (31),
- la fusion de la pâte à braser des plots de pâte à braser (20), notamment par le biais d'un flux d'air chaud, par passage dans un four de refusion et/ou par chauffage infrarouge, et/ou l'ajout d'un film support (10), notamment en polymère, pour la solidarisation des fils métalliques sur les cellules photovoltaïques (4, 4a, 4b, 4c, 4d),
- le positionnement de la première cellule photovoltaïque (4a) sur les fils métalliques (6b2) situés en regard de la partie ajourée (21v) du cadre (21), la face de la première cellule photovoltaïque (4a) comprenant déjà une interconnexion de fils métalliques (6b1) étant opposée à la partie ajourée (21v) du cadre (21),
- la fusion de la pâte à braser des plots de pâte à braser (20), notamment par le biais d'un flux d'air chaud, par passage dans un four de refusion et/ou par chauffage infrarouge, pour l'interconnexion des fils métalliques (6b2) sur la face de la première cellule photovoltaïque (4a) située en vis-à-vis de la partie ajourée (21v) du cadre (21), et/ou l'ajout d'un film support (10), notamment en polymère, pour la solidarisation des fils métalliques sur les cellules photovoltaïques (4, 4a, 4b, 4c, 4d),
- la découpe des fils métalliques (6b2) de part et d'autre des première (4a) et deuxième (4b) cellules photovoltaïques et le retrait de la série (S) formée par les première (4a) et deuxième (4b) cellules photovoltaïques.

14. Procédé de fabrication d'un module photovoltaïque (1) comportant :
- une première couche (2) transparente formant la face avant du module photovoltaïque (1), destinée à recevoir un flux lumineux,
- une pluralité de cellules photovoltaïques (4, 4a, 4b, 4c, 4d) disposées côte à côte et reliées électriquement entre elles par le procédé d'interconnexion de cellules photovoltaïques (4, 4a, 4b, 4c, 4d) selon l'une quelconque des revendications précédentes,
- un ensemble encapsulant (3) la pluralité de cellules photovoltaïques (4),
- une deuxième couche (5) formant la face arrière du module photovoltaïque (1), l'ensemble encapsulant (3) et la pluralité de cellules photovoltaïques (4, 4a, 4b, 4c, 4d) étant situés entre les première (2) et deuxième (5) couches.
